# EUROPÄISCHE PATENTSCHRIFT

(11) **EP 1 178 603 B1**
(45) Veröffentlichungstag und Bekanntmachung des Hinweises auf die Patenterteilung: **15.04.2009**
(21) Anmeldenummer: 01000339.0
(22) Anmeldetag: 02.08.2001
(51) Int. Cl.: H03F 3/343

(54) **Anpassschaltung für Audio- und Videosignale**
Interface for audio and video signals
Circuit adaptateur pour signaux audio et vidéo

(30) Priorität: 05.08.2000 DE 10038321
(43) Veröffentlichungstag der Anmeldung: 06.02.2002
(73) Patentinhaber: NXP B.V., 5656 AG Eindhoven (NL)
(72) Erfinder: Kühn, Hans-Jürgen c/o Philips Corp.I.P. GmbH, 52064, Aachen (DE)
(74) Vertreter: van der Veer, Johannis Leendert

(56) Entgegenhaltungen:
- EP-A- 0 664 606
- US-A- 4 318 052
- US-A- 4 525 683

## Beschreibung

Die Erfindung betrifft eine Schaltungsanordnung, insbesondere für ein Fernseh-, Multimedia-, Radio- oder Videoaufzeichnungsgerät, zum Übergang von einem Bereich niedriger Spannung auf einen Bereich höherer Spannung, gemäß dem Oberbegriff des Anspruchs 1 (vgl. EP-A-0 664 606).

Eine solche Schaltungsanordnung ist durch die Druckschrift DE 28 24 141 C2 bekannt. Dort ist eine Schaltungsanordnung zum Übergang von einer I²L-Schaltung auf eine vorzugsweise auf dem gleichen Halbleiter-Chip integrierte bipolare Schaltung höherer Ausgangsleistung mit einem pnp-Stromspiegel, der einen Signalstrom von der I²L-Logik in die bipolare Schaltung spiegelt, offenbart; parallel zum Eingang der letzten Inverterstufe der I²L-Schaltung ist die Emitter-Basis-Strecke eines bipolaren Transistors geschaltet, dessen Kollektor mit dem Eingang des pnp-Stromspiegels verbunden ist.

Zwar ermöglichst auch diese bekannte Schaltungsanordnung eine höhere Ausgangsleistung, jedoch erweist sich diese Schaltungsanordnung als den heutigen Erfordernissen technisch nicht gewachsen, wenn es darum geht, im Niedrigspannungsbereich eines elektrischen oder elektronischen Gerätes erzeugte und verarbeitete Signale in für den Geräteausgang geeignete Ausgangssignale höherer Spannung umzuwandeln, so wie dies heutzutage in einer Vielzahl elektrischer und elektronischer Geräte gerade auf dem Multimedia- oder auch auf dem Telekommunikationsgebiet erforderlich ist.

In diesem Zusammenhang ist zu berücksichtigen, dass an die Betriebsdauer und an die Spannungsfestigkeit derartiger elektrischer und elektronischer Geräte immer höhere Anforderungen gestellt werden, und zwar nicht zuletzt dann, wenn es sich um tragbare Geräte handelt. Hierbei ist die - in Zukunft wohl noch verstärkt zu beobachtende - Tendenz erkennbar, dass die Betriebsspannung von in derartigen Geräten eingesetzten immer weiter reduziert wird.
Der Erfindung liegt die Aufgabe zugrunde, eine Schaltungsanordnung der eingangs genannten Art bereitzustellen, die von einfacher sowie kostengünstiger Struktur ist und als Schnittstelle zwischen einem Bereich niedriger Spannung und einem Bereich höherer Spannung auch dann spannungsfest und zuverlässig arbeitet, wenn die Spannungsdifferenz zwischen dem Bereich niedriger Spannung und dem Bereich höherer Spannung groß ist, beispielsweise weil die integrierten Schaltkreise in einem Fernseh-, Multimedia-, Radio- oder Videoaufzeichnungsgerät mit sehr niedriger Betriebsspannung betrieben werden sollen, am Geräteausgang jedoch eine relativ hohe Ausgangsspannung benötigt wird.

Diese Aufgabe wird durch die im Anspruch 1 angegebenen Merkmale gelöst. Vorteilhafte Ausgestaltungen und zweckmäßige Weiterbildungen der vorliegenden Erfindung sind in den Unteransprüchen gekennzeichnet.

Gemäß der Lehre der vorliegenden Erfindung ist mittels der mindestens einen Anpassschaltung auf für den Fachmann überraschende Weise ein vorzugsweise analoges, insbesondere hochpräzises analoges Eingangssignal niedriger Stromstärke um einen Verstärkungsfaktor, der sich exemplarisch in der Größenordnung von 5 bewegen kann, in ein insbesondere analoges Ausgangssignal höherer Stromstärke verstärkbar.

Hierzu ist der Eingang der Anpaßschaltung dem Bereich niedriger Spannung zuordbar, beispielsweise indem dem Eingang der Anpaßschaltung mindestens eine als integrierte Schaltung ausgebildete Speise- oder Treiberschaltung vorgeschaltet ist, durch die die Anpaßschaltung mit dem Eingangssignal niedriger Stromstärke beaufschlagbar ist; die Speise- oder Treiberschaltung wiederum ist dann vorzugsweise an mindestens eine Niedrigspannungsquelle (Größenordnung beispielsweise etwa 1 V bis etwa 3,3 V) angeschlossen.

Die Anpaßschaltung weist ferner mindestens eine stromspiegelnden npn-Transistoranordnung und mindestens einen zum npn-Transistorstromspiegel in Serie geschalteten pnp-Stromspiegel auf, der an mindestens eine Hochspannungsquelle (Größenordnung beispielsweise etwa 12 V) angeschlossen ist, so dass die Verstärkung des Signals im pnp-Transistorstromspiegel erfolgen kann. Hierbei verhält sich der Ausgang des pnp-Transistorstromspiegels wie eine Stromquelle, was mit anderen Worten bedeutet, dass das die Anpaßschaltung verlassende Ausgangssignal gewissermaßen stromgetrieben, das heißt nicht spannungsgetrieben ist.

Um nun die Spannungsanpassung mittels der Anpaßschaltung zu realisieren, ist der Ausgang der Anpaßschaltung dem Bereich höherer Spannung zuordbar, wobei dem Ausgang der Anpaßschaltung mindestens ein vorzugsweise für Fernseh-, Multimedia-, Radio- oder Videoaufzeichnungsgeräte ausgelegter SCART (= Syndicat des Constructeurs d'Appareils Radio Receteurs et Televiseurs)-Ausgang nachgeschaltet sein kann.

Der Fachmann wird in bezug auf die vorliegende Erfindung insbesondere zu schätzen wissen, dass die Anpaßschaltung stromgetrieben ist und dass - im Gegensatz zur Druckschrift DE 28 24 141 C2 - innerhalb der Anpaßschaltung eine Verstärkung dieses Stroms erfolgt. Dies ist im Vergleich zur bekannten Anpaßschaltung, die im übrigen lediglich für digitale Signale einsetzbar ist, insofern von Vorteil, als stromgetriebene integrierte Schaltungen gegenüber elektromagnetischen Interferenzen und Störungen, insbesondere gegenüber induzierten induktiven und kapazitiven Störsignalen, ausgesprochen unempfindlich sind; hierbei handelt es sich um einen Vorteil, der auf dem Gebiet der integrierten Schaltungen bei zukünftigen Technologiegenerationen von zunehmender Bedeutung sein wird.

Ein weiterer Vorteil der vorliegenden Erfindung im Vergleich zur in der Druckschrift DE 28 24 141 C2 offenbarten Anpaßschaltung ist darin zu sehen, dass der überwiegende Teil einer "mixed analog/digital"-Technologie im wirtschaftlich günstigen Bereich niedriger Spannung mit daraus resultierenden erwünschten geringen Abmessungen des elektrischen oder elektronischen Geräts betrieben werden kann und dass lediglich die in Hochspannungstechnik zu betreibende Anpaßschaltung gemäß der vorliegenden Erfindung als weitere integrierte Schaltung für den beispielsweise bei einem SCART-Anschluß erforderlichen hohen Ausgangspegel sorgt. Zusätzlich ist vorteilhafterweise kein Koppelkondensator notwendig.

Somit ist es nicht erforderlich, alle Elemente der Schaltungsanordnung auf einem einzigen Chip unterzubringen; vielmehr kann eine strikte bauliche Trennung der Bereiche und Schaltungen niedriger Spannung von der Anpaßschaltung, der die mindestens eine Hochspannungsquelle zugeordnet ist, erfolgen; nicht zuletzt ist - im Gegensatz zur aus der Druckschrift DE28 24 141 C2 bekannten Anpaßschaltung mit dem RL-Element am positiven Potential - bei der vorliegenden Erfindung eine sogenannte "power supply ripple rejection" erzielbar, das heißt Schwankungen und Unstetigkeiten in der Spannungsversorgung können in zuverlässiger Manier verhindert werden.

Um eine hinreichende Flexibilität der Spannung des Ausgangssignals und zugleich eine hohe Genauigkeit des Ausgangspegels zu gewährleisten, ist dem Ausgang der Anpaßschaltung in bevorzugter Weise mindestens ein Widerstand zum Umwandeln des Ausgangssignals höherer Stromstärke in ein Ausgangssignal höherer Spannung nachgeordnet.

Ein Ausführungsbeispiel der vorliegenden Erfindung wird nachstehend anhand der Zeichnung näher erläutert. Es zeigt:

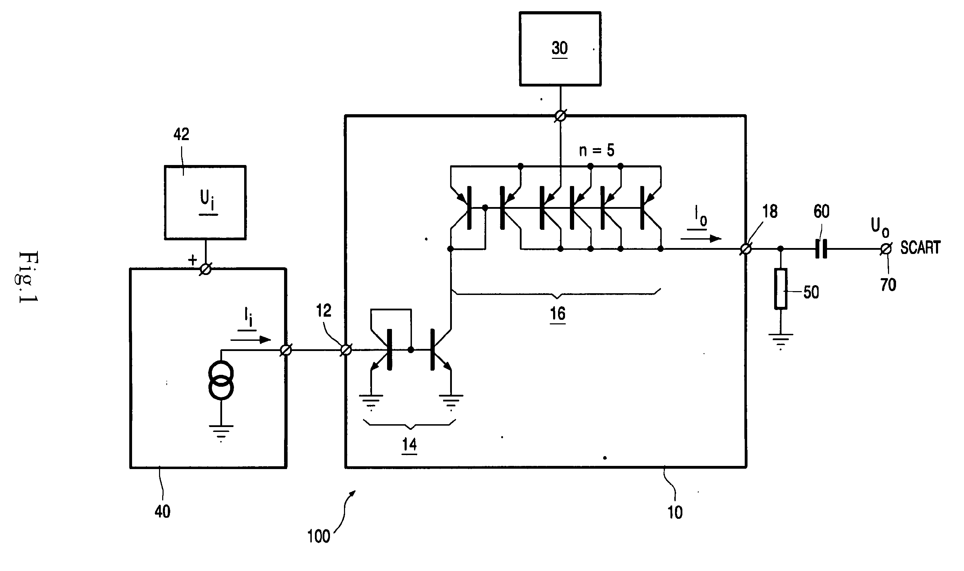

Fig 1 ein Ausführungsbeispiel einer Schaltungsanordnung gemäß der vorliegenden Erfindung in schematischer Prinzipdarstellung.

Die Schaltungsanordnung 100 ist zum Übergang von einem in Figur 1 linker Hand skizzierten Bereich niedriger Spannung Uᵢ auf einen in Figur 1 rechter Hand skizzierten Bereich höherer Spannung Uₒ bestimmt und zum Einsatz in einem Fernseh-, Multimedia-, Radio- oder Videoaufzeichnungsgerät vorgesehen.

Zentraler Bestandteil der Schaltungsanordnung 100 ist eine Anpaßschaltung 10, die ein Eingangssignal niedriger Stromstärke Iᵢ in ein Ausgangssignal höherer Stromstärke Iₒ verstärkt. Hierzu ist der Eingang 12 der Anpaßschaltung 10 dem Bereich niedriger Spannung Uᵢ zuordbar, indem dem Eingang 12 der Anpaßschaltung 10 eine Treiberschaltung 40 vorgeschaltet ist, durch die die Anpaßschaltung 10 mit dem Eingangssignal niedriger Stromstärke Iᵢ beaufschlagbar ist.

Die Treiberschaltung 40 ist an eine Niedrigsannungsquelle 42 angeschlossen, die eine niedrige Spannung Uᵢ im Bereich von etwa 1 V bis etwa 3,3 V bereitstellt und durch die die Treiberschaltung 40 ein Gleichstromsignal einer Stromstärke I_{i,dc} von etwa 1 mA abgibt, das von einem Wechselstromsignal einer Stromstärke I_{i,ac} von etwa 1,12 mA (gemessen von "peak" zu "peak") überlagert ist.

Derart niedrige Spannungswerte Uᵢ im Bereich von etwa 1 V bis etwa 3,3 V (und mithin derart niedrige Stromstärken Iᵢ in der Größenordnung von mA) sind zwar einerseits angesichts der Notwendigkeit, integrierte Schaltkreise mit sehr niedrigen Betriebsspannungen bereitzustellen, durchaus erwünscht; andererseits muß ein für den SCART-Ausgang 70 des Fernseh-, Multimedia-, Radio- oder Videoaufzeichnungsgeräts bestimmtes Signal eine Ausgangspegelbreite ("peak to peak") aufweisen, die die niedrigen Spannungswerte Uᵢ um ein Mehrfaches übersteigt.

Aus diesem Grunde weist die Anpaßschaltung 10 im Anschluß an ihren Eingang 12 eine npn-Transistoranordnung 14 auf, der als Stromspiegel fungiert, das Signal jedoch nicht verstärkt (Verhältnis 1:1). Dem npn-Transistorstromspiegel 14 in Reihe nachgeschaltet ist eine pnp-Transistoranordnung 16, der ebenfalls als Stromspiegel fungiert und im Gegensatz zum npn-Transistorstromspiegel 14 das Signal um den Verstärkungsfaktor 5 verstärkt (--> Verhältnis 1:5). Hierzu ist der pnp-Transistorstromspiegel 16 an eine Hochspannungsquelle 30 angeschlossen, die eine Spannung von etwa 12 V bereitstellt, so dass die Spannung der Hochspannungsquelle 30 die Spannung Uᵢ im Niedrigspannungsbereich (= Treiberschaltung 40) um ein Vielfaches übersteigt.

Im Anschluß an den pnp-Transistorstromspiegel 16 weist die Anpaßschaltung 10 den Ausgang 18 auf, der dem Bereich höherer Spannung Uₒ zuordbar ist und dem ein Widerstand 50 zum Umwandeln des Ausgangssignals höherer Stromstärke Iₒ in ein Ausgangssignal höherer Spannung

Uₒ nachgeordnet ist. Dieser Widerstand 50 bewegt sich in der Größenordnung von etwa 1 kΩ und bewirkt eine Umwandlung des Gleichstromsignals von einer Stromstärke I_{o,dc} (= n I_{i,dc}) von etwa 5 mA (=5 · 1 mA) in eine Spannung U_{o,dc} (= R · n · I_{i,dc}) von etwa 5 V (=1 kΩ · 5 · 1 mA); diese Umwandlung geht Hand in Hand mit einer Umwandlung des Wechselstromsignals von einer Stromstärke I_{o,ac} (= n · I_{i,ac}) von etwa 5,6 mA (= 5 · 1,12 mA;
gemessen von "peak" zu "peak") in eine Spannung U_{o,ac} (= R · n · I_{i,ac}) von etwa 5,6 V (= 1 kΩ · 5 · 1,12 mA; gemessen von "peak" zu "peak").

Hierbei ist es besonders vorteilhaft, dass die anhand Figur 1 veranschaulichte integrierte Anpaßschaltung 10 stromgetrieben, das heißt nicht etwa spannungsgetrieben ist, insbesondere was den Ausgang des pnp-Transistors 16 anbelangt, der gewissermaßen das Verhalten einer Stromquelle zeigt. Dies hat zur Folge, dass die Signale der Anpaßschaltung 10 gegenüber elektromagnetischen Interferenzen und Störungen ausgesprochen unempfindlich sind. Darüberhinaus konnte die Audio-Ausgangsspannungsaussteuerreserve im obigen Beispiel um etwa 5 dB gesteigert werden.

Obgleich dies der Darstellung gemäß Figur 1 nicht explizit entnehmbar ist, kann die Schaltungsanordnung gemäß der vorliegenden Erfindung auch mehr als eine Anpaßschaltungsstufe aufweisen. So können etwa in bevorzugter Weise vier Anpaßschaltungsstufen für zwei SCART-Stereo-Ausgänge vorgesehen sein, wobei die Schaltungsanordnung dann acht npn-Transistoren und 24 pnp-Transistoren umfaßt und wobei den vier Anpaßschaltungen dann jeweils ein Widerstand nachgeordnet ist.

Abschließend sei noch darauf hingewiesen, dass mit der Schaltungsanordnung gemäß der vorliegenden Erfindung keine nennenswerte Veränderung der sogenannten gesamten harmonischen Signalverzerrung (= THD = Total Harmonic Distortion) erzielbar ist. Dieser Vorteil wird durch die nachfolgende Tabelle veranschaulicht, in der die jeweilige gesamte harmonische Signalverzerrung (in dB = Dezibel) bei gegebener Frequenz f (in kHz = Kilohertz) und bei gegebenem, sich durch Quadratwurzelziehen aus dem durchschnittlichen Quadrat (rms = root mean square) ergebendem Effektivwert der Ausgangsspannung U_{o,rms} (in V = Volt) wiedergegeben ist:

Zu berücksichtigen ist in diesem Zusammenhang, dass die vorstehenden Werte mit einem von einem Wechselstromsignal einer Stromstärke I_{i,ac} von etwa 1,7 mA (gemessen von "peak" zu "peak") überlagerten Gleichstromsignal einer Stromstärke I_{i,dc} von etwa 1,7 mA erzielt wurden, dass der Verstärkungsfaktor n = 3 betrug und dass der durch eine 12V-Hochspannungsquelle 30 gespeisten Anpaßschaltung ein 1 kΩ-Widerstand 50 und eine 2,2nF-Last (nicht eingezeichnet von 70 nach Masse) nachgeschaltet waren.

Obwohl diese Kenndaten teilweise geringfügig von den Kenndaten der anhand Figur 1 beschriebenen Schaltungsanordnung 100 abweichen, dokumentieren die vorstehenden Meßwerte der gesamten harmonischen Signalverzerrung die Überlegenheit der erfindungsgemäßen Schaltungsanordnung gegenüber konventionellen Schaltungsanordnungen, insbesondere im Hinblick auf das Erfüllen der Erfordernisse des Dolby Digital C-Standards und auf das Fehlen jeglicher parasitärer Schwingungen selbst unter Vollastbetrieb.

### Bezugszeichenliste

- 100: Schaltungsanordnung
- 10: Anpaßschaltung
- 12: Eingang der Anpaßschaltung 10
- 14: npn-Transistorstromspiegel
- 16: Stromspiegel
- 18: Ausgang der Anpaßschaltung 10
- 30: Hochspannungsquelle
- 40: Speise- oder Treiberschaltung
- 42: Niedrigspannungsquelle
- 50: Widerstand
- 60: Koppelkondensator
- 70: SCART-Ausgang
- n: Verstärkungsfaktor
- Iᵢ: niedrige Stromstärke des Eingangssignals
- Iₒ: höhere Stromstärke des Ausgangssignals
- Uᵢ: niedrige Spannung
- Uₒ: höhere Spannung

## Patentansprüche

1. Schaltungsanordnung, insbesondere für ein Fernseh-, Multimedia-, Radio- oder Videoaufzeichnungsgerät, zum Übergang von einem Bereich niedriger Spannung (Uᵢ) auf einen Bereich höherer Spannung (Uₒ), mit mindestens einer ein insbesondere analoges Eingangssignal niedriger Stromstärke (Iᵢ) um einen Verstärkungsfaktor (n) in ein insbesondere analoges Ausgangssignal höherer Stromstärke (Iₒ) verstärkenden Anpaßschaltung (10),
- deren Eingang (12) dem Bereich niedriger Spannung (Uᵢ) zuordbar ist,
- deren Ausgang (18) dem Bereich höherer Spannung (Uₒ) zuordbar ist und die
- mindestens einen npn-Transistorstromspiegel (14) oder NMOS-Stromspiegel, und mindestens einen zum npn-Transistorstromspiegel (14) oder NMOS-Stromspiegel in Serie geschalteten, an mindestens eine Hochspannungsquelle (30) angeschlossenen pnp-Stromspiegel (16) oder PMOS-Stromspiegel aufweist,
**dadurch gekennzeichnet, dass**
- der pnp-Stromspiegel (16) auf seiner dem Ausgang (18) der Anpaßschaltung (10) zugewandten Seite mehrere (n) zueinander parallel geschaltete pnp-Transistoren aufweist oder der PMOS-Stromspiegel auf seiner dem Ausgang (18) der Anpaßschaltung (10) zugewandten Seite mehrere (n) zueinander parallel geschaltete PMOS -Transistoren aufweist, und
- dass dem Ausgang (18) der Anpaßschaltung (10) mindestens ein SCART (= Syndicat des Constructeurs d'Appareils Radio Receteurs et Televiseurs)-Ausgang (70) nachgeschaltet ist.

2. Schaltungsanordnung gemäß Anspruch 1, **dadurch gekennzeichnet, dass** der Verstärkungsfaktor (n) etwa 5 beträgt.

3. Schaltungsanordnung gemäß Anspruch 1 oder 2, **dadurch gekennzeichnet, dass** die Verstärkung des Signals im pnp-Stromspiegel (16)/ PMOS-Stromspiegel oder im npn-Transistorstromspiegel (14)/NMOS-Stromspiegel erfolgt.

4. Schaltungsanordnung gemäß mindestens einem der Ansprüche 1 bis 3, **dadurch gekennzeichnet, dass** die Hochspannungsquelle (30) eine Spannung in der Größenordnung von etwa 12 V bereitstellt.

5. Schaltungsanordnung gemäß mindestens einem der Ansprüche 1 bis 4, **dadurch gekennzeichnet, dass** dem Eingang (12) der Anpaßschaltung (10) mindestens eine Speise- oder Treiberschaltung (40) vorgeschaltet ist, durch die die Anpaßschaltung (10) mit dem Eingangssignal niedriger Stromstärke (Iᵢ) beaufschlagbar ist.

6. Schaltungsanordnung gemäß Anspruch 5, **dadurch gekennzeichnet, dass** die Speise- oder Treiberschaltung (40) an mindestens eine Niedrigspannungsquelle (42) angeschlossen ist.

7. Schaltungsanordnung gemäß Anspruch 6, **dadurch gekennzeichnet, dass** die Niedrigspannungsquelle (42) eine Spannung in der Größenordnung von etwa 1 V bis etwa 3,3 V bereitstellt.

8. Schaltungsanordnung gemäß mindestens einem der Ansprüche 1 bis 8, **dadurch gekennzeichnet, dass** dem Ausgang (18) der Anpaßschaltung (10) mindestens ein Widerstand (50) zum Umwandeln des Ausgangssignals höherer Stromstärke (Iₒ) in ein Ausgangssignal höherer Spannung (Uₒ) nachgeordnet ist.

9. Schaltungsanordnung gemäß Anspruch 9, **dadurch gekennzeichnet, dass** der Widerstand (50) in der Größenordnung von etwa 1 kΩ liegt.

10. Schaltungsanordnung gemäß mindestens einem der Ansprüche 1 bis 10, **dadurch gekennzeichnet, dass** die Anpaßschaltung (10) mehrstufig ist und/oder dass mehr als eine Anpaßschaltung (10) vorgesehen ist.

11. Schaltungsanordnung gemäß Anspruch 11, **dadurch gekennzeichnet, dass** acht npn-Transistoren (14)/NMOS-Transistoren und 24 pnp-Transistoren (16)/PMOS-Transistoren vorgesehen sind und dass der vierstufigen Anpaßschaltung (10) bzw. den vier Anpaßschaltungen (10) jeweils ein Widerstand (50) nachgeordnet ist.

12. Fernseh-, Multimedia-, Radio- oder Videoaufzeichnungsgerät, aufweisend mindestens eine Schaltungsanordnung (100) gemäß mindestens einem der Ansprüche 1 bis 12.

## Claims

1. A circuit arrangement, in particular for a television, multimedia, radio or video recording device, for the transition from a range of low voltage (Uᵢ) to a range of higher voltage (Uₒ), comprising at least one adaptor circuit (10) which amplifies an in particular analog input signal of low current strength (Iᵢ) by a gain factor (n) to an in particular analog output signal of a higher current strength (Iₒ) and
- whose input (12) can be associated with the range of low voltage (Uᵢ) and
- whose output (18) can be associated with the range of higher voltage (Uₒ) and which has
- at least one npn transistor current mirror (14) or NMOS current mirror, and at least one pnp current mirror (16) or PMOS current mirror connected in series with the npn transistor current mirror (14) or NMOS current mirror and connected to at least one high-voltage source (30),
**characterised in that**
- the pnp current mirror (16) on its side towards the output (18) of the adaptor circuit (10) has a plurality (n) of pnp transistors connected in parallel relationship with each other or the PMOS on its side towards the output (18) of the adaptor circuit (10) has a plurality (n) of PMOS transistors connected in parallel relationship with each other, and
- at least one SCART (=Syndicat des Constructeurs d'Appareils Radio Recepteurs et Televiseurs) output (70) is connected downstream of the output (18) of the adaptor circuit (10).

2. A circuit arrangement according to claim 1 **characterised in that** the gain factor (n) is about 5.

3. A circuit arrangement according to claim 1 or claim 2 **characterised in that** amplification of the signal is effected in the pnp current mirror (16)/PMOS current mirror or in the npn transistor current mirror (14)/NMOS current mirror.

4. A circuit arrangement according to at least one of claims 1 to 3 **characterised in that** the high-voltage source (30) provides a voltage of the order of magnitude of about 12 V.

5. A circuit arrangement according to at least one of claims 1 to 4 **characterised in that** connected upstream of the input (12) of the adaptor circuit (10) is at least one supply or driver circuit (40) by which the input signal of low current strength (Iᵢ) can be applied to the adaptor circuit (10).

6. A circuit arrangement according to claim 5 **characterised in that** the supply or driver circuit (40) is connected to at least one low-voltage source (42).

7. A circuit arrangement according to claim 6 **characterised in that** the low-voltage source (42) provides a voltage of the order of magnitude of about 1 V to about 3.3 V.

8. A circuit arrangement according to at least one of claims 1 to 7 **characterised in that** connected downstream of the output (18) of the adaptor circuit (10) is at least one resistor (50) for converting the output signal of higher current strength (Iₒ) into an output signal of higher voltage (Uₒ).

9. A circuit arrangement according to claim 8 **characterised in that** the resistor (50) is of the order of magnitude of about 1 kΩ.

10. A circuit arrangement according to at least one of claims 1 to 9 **characterised in that** the adaptor circuit (10) is multi-staged and/or there is more than one adaptor circuit (10).

11. A circuit arrangement according to claim 10 **characterised in that** there are eight npn transistors (14)/NMOS transistors and 24 pnp transistors (16)/PMOS transistors and that connected downstream of the four-stage adaptor circuit (10) or the four adaptor circuits (10) is a respective resistor (50).

12. A television, multimedia, radio or video recording device comprising at least one circuit arrangement (100) according to at least one of claims 1 to 11.

## Revendications

1. Agencement de circuits, notamment pour téléviseur, appareil multimédia, poste de radio ou magnétoscope, permettant la transition d'une région de basse tension (Uᵢ) à une région de tension plus élevée (Uₒ), ledit agencement de circuits comportant au moins un circuit d'adaptation (10) qui amplifie un signal d'entrée, notamment analogique, de faible intensité (Iᵢ) avec un facteur d'amplification (n) pour donner un signal de sortie, notamment analogique, d'intensité plus élevée (Iₒ),
- dont l'entrée (12) peut être associée à la région de basse tension (Uᵢ),
- dont la sortie (18) peut être associée la région de tension plus élevée (Uₒ) et qui
- comporte au moins un miroir de courant à transistors npn (14) ou miroir de courant NMOS et au moins un miroir de courant à transistors pnp (16) ou miroir de courant PMOS raccordé à au moins une source de haute tension (30) et monté en série avec le miroir de courant à transistors npn (14) ou miroir de courant NMOS,
**caractérisé en ce que**
- le miroir de courant pnp (16) comporte, sur son côté dirigé vers la sortie (18) du circuit d'adaptation (10), plusieurs (n) transistors pnp montés en parallèle ou le miroir de courant PMOS comporte, sur son côté dirigé vers la sortie (18) du circuit d'adaptation (10), plusieurs transistors PMOS montés en parallèle, et
- au moins une sortie SCART (Syndicat des Constructeurs d'Appareils radiorécepteurs et de téléviseurs) (70) est montée en aval de la sortie (18) du circuit d'adaptation (10).

2. Agencement de circuits selon la revendication 1, **caractérisé en ce que** le facteur d'amplification (n) est d'environ 5.

3. Agencement de circuits selon la revendication 1 ou 2, **caractérisé en ce que** l'amplification du signal est effectuée dans le miroir de courant pnp (16)/miroir de courant PMOS ou dans le miroir de courant à transistors npn (14)/miroir de courant NMOS.

4. Agencement de circuits selon au moins une des revendications 1 à 3, **caractérisé en ce que** la source de haute tension (30) délivre une tension dont l'ordre de grandeur est d'environ 12 V.

5. Agencement de circuits selon au moins une des revendications 1 à 4, **caractérisé en ce qu'**au moins un circuit d'alimentation ou d'attaque (40), permettant d'alimenter le circuit d'adaptation (10) avec un signal d'entrée de faible intensité (Iᵢ), est monté en amont de l'entrée (12) du circuit d'adaptation (10).

6. Agencement de circuits selon la revendication 5, **caractérisé en ce que** le circuit d'alimentation ou d'attaque (40) est raccordé à au moins une source de basse tension (42).

7. Agencement de circuits selon la revendication 6, **caractérisé en ce que** la source de faible tension (42) délivre une tension dont l'ordre de grandeur est d'environ 1 V à environ 3,3 V.

8. Agencement de circuits selon au moins une des revendications 1 à 8, **caractérisé en ce qu'**au moins une résistance (50), destinée à convertir le signal de sortie d'intensité plus élevée (I₀) en un signal de sortie de tension plus élevée (U₀), est montée en aval de la sortie (18) du circuit d'adaptation (10).

9. Agencement de circuits selon la revendication 9, **caractérisé en ce que** l'ordre de grandeur de la résistance (50) est d'environ 1 kΩ.

10. Agencement de circuits selon au moins une des revendications 1 à 10, **caractérisé en ce que** le circuit d'adaptation (10) possède plusieurs étages et **en ce qu'**il est prévu plus d'un circuit d'adaptation (10).

11. Agencement de circuits selon la revendication 11, **caractérisé en ce qu'**il est prévu huit transistors npn (14)/transistors NMOS et 24 transistors pnp (16)/transistors PMOS et **en ce qu'**une résistance (50) est montée à chaque fois en aval du circuit d'adaptation à quatre étages (10) respectivement des quatre circuits d'adaptation (10).

12. Téléviseur, appareil multimédia, poste de radio ou magnétoscope, comportant au moins un agencement de circuits (100) selon au moins une des revendications 1 à 12.
